(19) Europäisches Patentamt
European Patent Office
Office européen des brevets

(11) **EP 4 210 220 A1**

(12) **EUROPEAN PATENT APPLICATION**

(43) Date of publication:
**12.07.2023 Bulletin 2023/28**

(21) Application number: **23150393.9**

(22) Date of filing: **05.01.2023**

(51) International Patent Classification (IPC):
**H03F 3/45** (2006.01)     **H03F 1/30** (2006.01)
**H03G 3/30** (2006.01)     **G01R 19/32** (2006.01)

(52) Cooperative Patent Classification (CPC):
**H03F 3/45475; G01R 19/32; H03F 1/30;**
**H03G 3/301;** H03F 2200/21; H03F 2200/462;
H03F 2200/471; H03F 2200/481;
H03F 2203/45151; H03F 2203/45286;
H03F 2203/45528; H03F 2203/45594;
H03F 2203/45596; H03F 2203/45601;
H03F 2203/45604;          (Cont.)

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **07.01.2022 US 202263297329 P**
**03.01.2023 US 202318149331**

(71) Applicant: **Semiconductor Components**
**Industries, LLC**
**Phoenix, AZ 85008 (US)**

(72) Inventor: **DUFFY, Thomas Patrick**
**Chandler, Arizona, 85225 (US)**

(74) Representative: **Manitz Finsterwald**
**Patent- und Rechtsanwaltspartnerschaft mbB**
**Martin-Greif-Strasse 1**
**80336 München (DE)**

(54) **CURRENT SENSE CIRCUIT HAVING A TEMPERATURE COMPENSATED RESPONSE**

(57)      A package for a current sense circuit may include a lead-frame having a shunt resistance configured to generate a shunt voltage, which can be used to measure a current through the lead-frame. The shunt resistance associated with the lead-frame may be highly variable with temperature, which can cause errors in the current measurement. Accordingly, a current sense circuit can include an amplifier with an input resistor having a composite temperature coefficient configured to match a lead-frame temperature coefficient so that an output of the amplifier is compensated to remove variations in the shunt resistance of the lead-frame due to temperature.

**FIG. 4**

EP 4 210 220 A1

(52) Cooperative Patent Classification (CPC): (Cont.)
H03F 2203/45698; H03G 2201/708

**Description**

CROSS-REFERENCE TO RELATED APPLICATION

This application claims priority to U.S. Provisional Application, No. 63/297,329 filed on January 7, 2022, which is hereby incorporated by reference in its entirety.

FIELD OF THE DISCLOSURE

The present disclosure relates to microelectronics and more specifically to a current sense circuit configured to output a signal corresponding to a current in a shunt resistor.

BACKGROUND

Current sensing may include measuring a voltage generated by a current passing through a shunt resistor. Thermally stable (i.e., high accuracy) shunt resistors may be too large and expensive for some applications.

SUMMARY

In some aspects, the techniques described herein relate to a package for a current sense circuit including; a lead-frame having a shunt resistance configured to generate a shunt voltage between a positive terminal and a negative terminal, the shunt voltage corresponding to a current through the lead-frame, the shunt resistance having a variation with temperature according to a lead-frame temperature coefficient; and a die including a differential amplifier coupled to the positive terminal of the lead-frame and to the negative terminal of the lead-frame, the differential amplifier including: an input resistor having a composite temperature coefficient configured to match the lead-frame temperature coefficient such that an output of the differential amplifier is a measurement of the shunt voltage and such that the output is compensated to remove the variation caused by the lead-frame temperature coefficient.

In some aspects, the techniques described herein relate to a method for reducing a variation in a current measurement, the method including: receiving a current at a lead-frame of a package to generate a shunt voltage corresponding to the current, the shunt voltage changing with temperature over a range according to a lead-frame temperature coefficient; measuring the shunt voltage with an amplifier to output the current measurement, the amplifier having a gain that is a function of an input resistor; and configuring the input resistor to change with temperature such that a change in the shunt voltage caused by a temperature change is compensated by an opposite change in the gain of the amplifier.

The foregoing illustrative summary, as well as other exemplary objectives and/or advantages of the disclosure, and the manner in which the same are accomplished, are further explained within the following detailed description and its accompanying drawings.

BRIEF DESCRIPTION OF THE DRAWINGS

FIG. 1 is a schematic block diagram of a system including a current sense circuit according to a possible implementation of the present disclosure.

FIG. 2 is a top plan view of a lead-frame of a package according to a possible implementation of the present disclosure.

FIG. 3A are graphs illustrating temperature responses of various parameters of a current sense circuit without temperature compensation according to a possible implementation of the present disclosure.

FIG. 3B are graphs illustrating temperature responses of various parameters of a current sense circuit with temperature compensation according to a possible implementation of the present disclosure.

FIG. 4 is a schematic of a current sense circuit according to a possible implementation of the present disclosure.

FIG. 5 are graphs illustrating temperature responses of a composite resistance and its component first resistance and a second resistance according to an implementation of the present disclosure.

FIG. 6 is a perspective view of a package for a current sense circuit according to a possible implementation of the present disclosure.

FIG. 7 is a flowchart of a method for reducing a variation in a current measurement according to a possible implementation of the present disclosure.

The components in the drawings are not necessarily to scale relative to each other. Like reference numerals designate corresponding parts throughout the several views.

## DETAILED DESCRIPTION

Current in a circuit may be sensed using a resistor in series with the circuit. To measure the current through the resistor, a voltage measurement circuit may be placed in a parallel connection (i.e., in shunt) with the resistor (i.e., shunt resistor) to obtain a voltage measurement (i.e., response) proportional to the current. Shunt resistors for these measurements may be configured to have very low resistance (e.g., < 10 milliohm ($m\Omega$)) to prevent excessive loading of the circuit and to prevent heating. Further, these shunt resistors may be configured to have a resistance that remains accurate (e.g., < 0.1% change) across a temperature range (e.g., - 40 °C $\leq$ T $\leq$ 150 °C). These characteristics may add size and cost to the shunt resistor, which can prevent their use in some applications. Additionally, the added size can make packaging these shunt resistors with voltage measurement circuitry problematic. Accordingly, it may be highly desirable to reduce the cost and size of a shunt resistor.

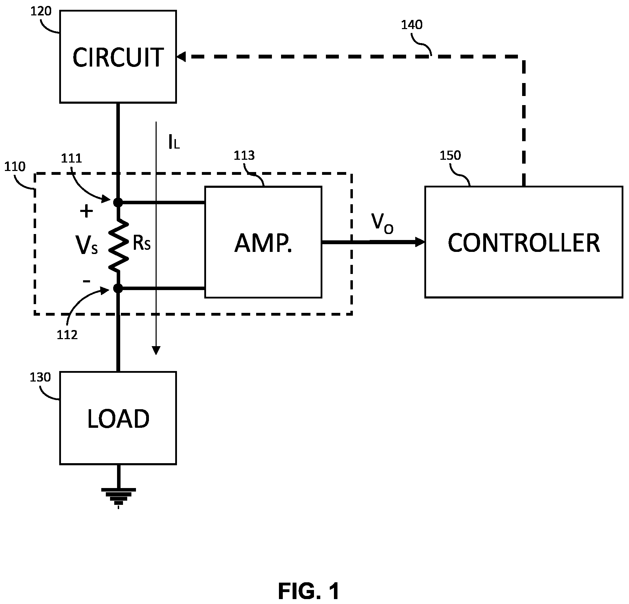

FIG. 1 is a schematic block diagram of a system including a current sense circuit according to a possible implementation of the present disclosure. As shown, a shunt resistor ($R_S$) may be placed in series with a circuit 120 configured to transmit a current ($I_L$) to a load 130. The shunt resistor ($R_S$) is part of a current sense circuit 110 that further includes an amplifier 113. The current ($I_L$) flowing through the shunt resistor ($R_S$) can generate a shunt voltage ($V_S$) between a positive terminal 111 and a negative terminal 112. The amplifier 113 is configured to output an output voltage ($V_O$) that is a function of (e.g., proportional to) the current ($I_L$).

The output voltage (i.e., response, current measurement) may be transmitted to a controller 150 and/or processor which may be configured (e.g., by software instructions) to generate feedback 140 to control the circuit 120 based on the sensed (i.e., measured) current. Accordingly, it may be highly desirable for the current to be measured accurately to provide stable control of the circuit. The present disclosure describes current measurement circuit, and package thereof, to provide a low-cost integrated shunt resistor while providing accurate current measurements.

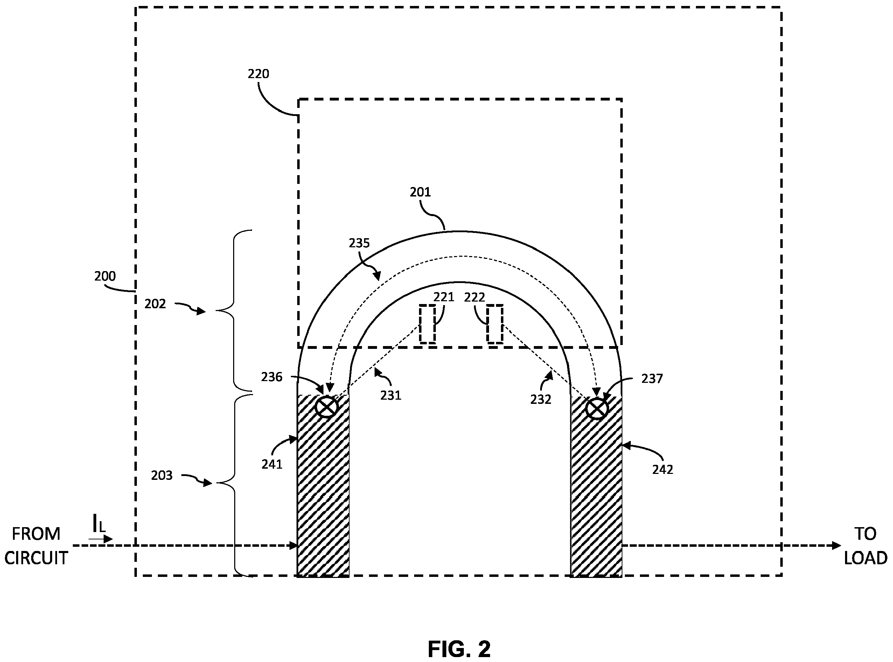

FIG. 2 is a top plan view of a lead-frame of a package according to a possible implementation of the present disclosure. As shown, a lead-frame 201 of a package 200 may be coupled between a circuit and a load so that the ohmic resistance of the lead-frame is the shunt resistance (Rs) of the current sense circuit (e.g., see FIG. 1). The lead-frame includes a positive terminal portion (i.e., positive terminal 241), a negative terminal portion (i.e., negative terminal 242), and a loop portion 202 therebetween.

A die 220 may be mechanically and thermally coupled to the loop portion 202 of the lead-frame 201. For example, the die 220 may be bonded to the loop portion 202 so that a bottom surface of the die is in contact with a top surface of the lead-frame. The die may include a positive pad 221 and a negative pad 222 coupled to circuitry (e.g., amplifier) on the die. The positive pad 221 may be electrically coupled to the positive terminal 241 by a first wire-bond 231 and the negative pad 222 may be electrically coupled to the negative terminal 242 by a second wire-bond 232.

The die 220 may include an amplifier (e.g., differential amplifier) coupled between the positive pad 221 and the negative pad 222 that is configured to measure a shunt voltage between the positive terminal 241 and the negative terminal 242 via Kelvin connections formed by the wire-bonds to the lead-frame. The shunt voltage may be generated by a current flowing through a shunt resistance of the lead-frame. In particular, the current may flow into the package positive terminal 241 (from the circuit), through the loop portion 202, and then flow out of the negative terminal 242 (to the load). Accordingly, the positive terminal 241 and the negative terminal 242 may be terminals or pads configured to be electrically coupled (e.g., soldered) to other circuitry (e.g., one a printed circuit board (PCB)).

The shunt resistance of the lead-frame may correspond to a length and a thickness of the lead-frame 201 between Kelvin connections formed between the wire-bonds 231,232 and the lead-frame 201. For example, a first position 236 of the first wire-bond 231 on the lead-frame 201 and a second position 237 of the second wire-bond 232 on the lead-frame 201 may define a length 235, and the shunt resistance of the lead-frame 201 may correspond to the length 235. Accordingly, the shunt resistance of the lead-frame 201 may be controlled, or adjusted, based on the first position 236 and the second position 237 of the first wire-bond 231 and the second wire-bond 232, respectively.

The shunt resistance of the lead-frame 201 may further correspond to a loop thickness of the lead-frame 201 between the first position 236 of the first wire-bond 231 and the second position 237 of the second wire-bond 232. In a possible implementation, the loop portion 202 of the lead-frame may have a loop thickness, while a terminal portion 203 of the lead-frame 201 may have a terminal thickness. For example, the terminal thickness may be larger than the loop thickness so that the loop portion 202 forms a cantilevered surface above a bottom surface of the package 200 (i.e., above a printed circuit board (PCB)). In this case, the die 220 may rest on the cantilevered surface. The die 220 and the lead-frame 201 may be molded within a material that forms the exterior surfaces of the package 200, with portions of the lead-frame 201 exposed to provide connection points to external circuitry (e.g., to traces on a PCB). The shunt resistance of the lead-frame 201 may further correspond to a material of the lead-frame. In a possible implementation, the lead-frame may be a copper alloy, such as C194 copper-iron alloy.

The shunt resistance of the lead-frame may change with temperature. A lead-frame temperature coefficient may describe this change as the rate (i.e., slope) at which the shunt-resistance changes over a range of temperatures (e.g., percent-change/range). The disclosed current sensing approach does not attempt to make the lead-frame temperature coefficient zero. Instead, the described approach uses temperature compensation to accommodate for a non-zero lead-frame temperature coefficient. As a result, a package including the shunt resistance and the current sense circuit can be made smaller, with the lead-frame of the package configured to couple the current sense circuit to external circuitry and to provide the shunt resistance. In other words, the lead-frame has a dual-purpose.

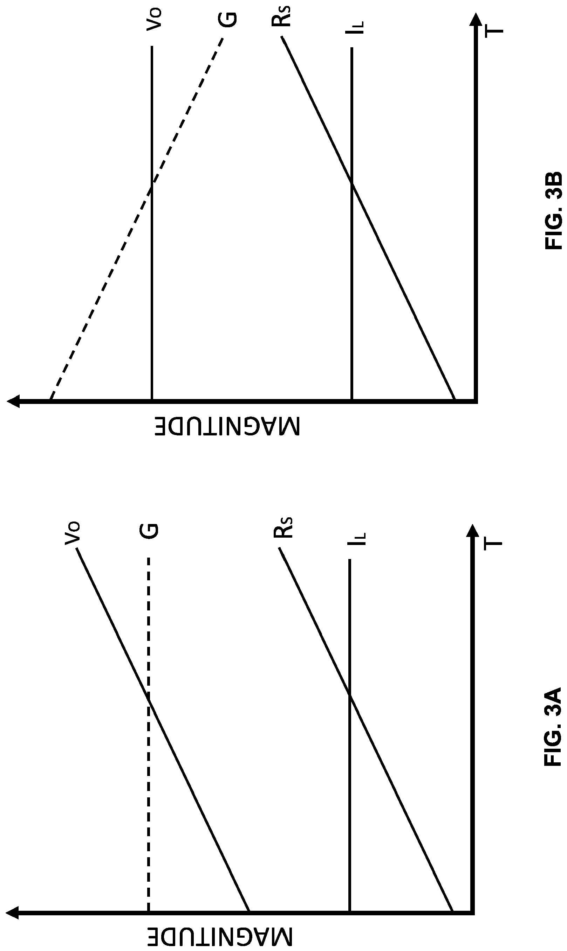

FIG. 3A are graphs illustrating temperature responses of various parameters of a current sense circuit before temperature compensation. The graphs may be understood in reference to the parameters illustrated in FIG. 1 using a lead-frame as the shunt resistance ($R_S$). As shown, a magnitude of a current ($I_L$) is constant over a range of temperatures (T). A measurement ($V_O$) of the current ($I_L$) is not constant over the range of temperatures (T) and is therefore an inaccurate measurement of the current. As discussed above, the shunt resistance ($R_S$) of the lead-frame changes with temperature (T), thereby making the shunt voltage ($V_S$) generated by the current ($I_L$) change proportionally. Accordingly, when the gain (G) of an amplifier used to sense the shunt voltage is constant with temperature, as shown in FIG. 3A, the measurement of the current (Vo) will change in proportion to the change in shunt resistance (Rs) (i.e., according to the lead-frame temperature coefficient).

FIG. 3B are graphs illustrating temperature responses of various parameters of a current sense circuit with temperature compensation according to a possible implementation of the present disclosure. As shown, a magnitude of a current ($I_L$) is constant over a range of temperatures (T). A measurement ($V_O$) of the current ($I_L$) is made more accurate by configuring the gain (G) of the current sense circuit to change in a way that compensates for the changing the shunt resistance ($R_S$). For example, an increase in the shunt resistance ($R_S$) may be compensated for by a corresponding decrease in the gain (G) of the current sense circuit, and vice versa. In other words, the shunt resistance ($R_S$) may have a first variation (i.e., first profile, first change, first slope, etc.) with temperature according to a lead-frame temperature coefficient, while the gain (G) may have a second variation with temperature that is opposite (i.e., inverse, negative) the first variation.

The compensated gain can remove the variation in the measurement of the current caused by the lead-frame temperature coefficient. As a result, the measurement ($V_O$) of the current ($I_L$) is constant over temperature, and the current sense circuit 110 operates as if there were no variations in the shunt resistance ($R_S$) (i.e., lead-frame) with temperature. The disclosed current sense circuit has a gain configured to change with temperature in order to remove a variation caused by a (non-zero) lead-frame temperature coefficient of the shunt resistance.

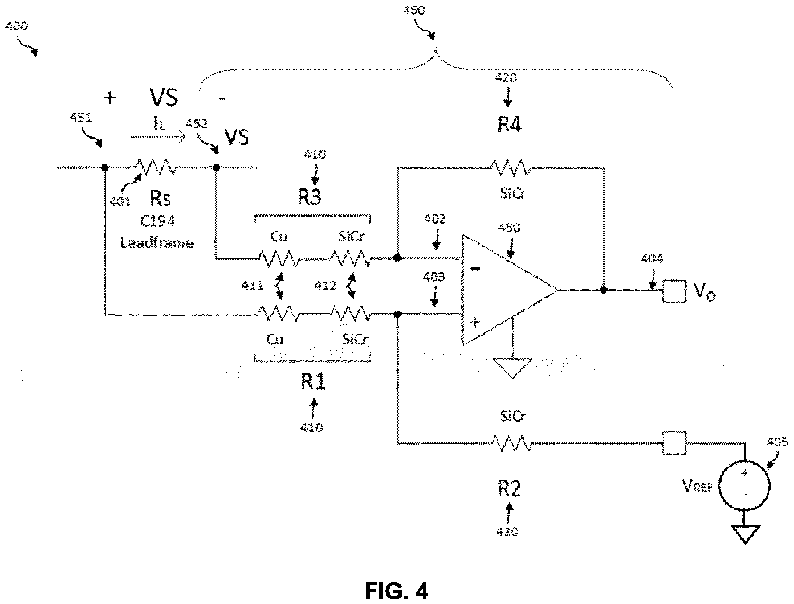

FIG. 4 is a schematic of a current sense circuit according to a possible implementation of the present disclosure. The current sense circuit 400 is configured to measure a shunt voltage (Vs) of a shunt resistance 401 (Rs), which as discussed can be implemented as a lead-frame of a package. The current sense circuit 400 includes a differential amplifier 460. The differential amplifier is configured to generate a voltage (Vo) corresponding to a current measurement at an output 404 that is proportional to a difference in voltage between a first voltage at a positive terminal 451 and a second voltage at a negative terminal 452. The negative terminal 452 is coupled to an inverting input 402 of the operational amplifier 450 (i.e., opamp) via a resistor, R3. The positive terminal 451 is coupled to a non-inverting input 403 of an operational amplifier 450 via a resistor, R1. The resistors, R1 and R3, may be equal and referred to interchangeably as an input resistor 410 of the differential amplifier (i.e., R1 = R3 = $R_{IN}$). An output 404 of the differential amplifier 460 is coupled to the inverting input 402 via a resistor, R4. A reference potential 405 ($V_{REF}$) is coupled to the non-inverting input 403 via a resistor, R2. In a possible implementation, the reference potential 405 equals zero volts (i.e., a short) so that a ground is coupled to the non-inverting input 403 via the resistor R2. The resistors, R2 and R4, may be equal and referred to interchangeably as a feedback resistor of the differential amplifier (i.e., R2 = R4 = $R_F$).

When the resistances are balanced as described above (i.e., R1 = R3, R2 = R4) the gain of the differential amplifier can be described by the equation below.

$$V_O = V_{REF} + G(V_s) = V_{REF} + \frac{R_F}{R_{IN}}(V_S) = V_{REF} + \frac{R_F \cdot R_S}{R_{IN}} \cdot I_L \qquad (1)$$

As mentioned, $V_{REF}$ may be zero and the shunt resistance, $R_S$, may have a variation with temperature corresponding to a lead-frame coefficient. For example, in the equation above, the shunt resistance, $R_S$, may increase linearly over a range of temperatures according to the lead-frame temperature coefficient. To cancel this increase in the equation above, the input resistance, $R_{IN}$, may be increased similarly. In other words, a temperature change that causes an increase in shunt resistance ($R_S$) may similarly cause an increase in input resistance ($R_{IN}$), which reduces the gain ($R_F/R_{IN}$) of the differential amplifier 460. The decreased gain removes the error in current measurement that would otherwise be caused by a shunt-resistance that fluctuates with temperatures. Accordingly, the differential amplifier 460 is said to have an output (i.e., current measurement, response) that is temperature compensated (i.e., compensated)

The gain of the amplifier can be decreased with temperature by increasing the input resistance with temperature, while the feedback resistance is approximately constant. When the gain reduction substantially cancels the input voltage (VS) increase, the current measurement is compensated. An accuracy of the compensation can correspond to an accuracy of the measurement with temperature. Accordingly, the present disclosure describes a differential amplifier 460 having an input resistor 410 that can be configured to have a temperature coefficient that substantially matches the lead-frame temperature coefficient over a range of temperatures and a feedback resistor 420 that remains substantially constant over the range of temperatures.

The input resistor can have composite resistance that includes a plurality of resistances having a plurality of (different) temperature coefficients, which combine to generate a composited temperature coefficient that substantially matches the lead-frame temperature coefficient.

As shown in FIG. 4, the input resistor 410 can include a first resistance 411 having a first temperature coefficient in series with a second resistance 412 having a second temperature coefficient. The first temperature coefficient and the second temperature coefficient may combine so that the input resistance changes with temperature according to a composite temperature coefficient for the combined resistance.

The first resistance 411 and the second resistance 412 may be configured (i.e., tuned) using material selection and resistance trimming. The first resistance 411 may be a first material. The first material may be any material having a temperature coefficient that is greater than or equal to the lead-frame temperature coefficient. For example, the first material may be copper (Cu) or a copper alloy. The first resistance 411 (i.e., $R_{Cu}$) may change with temperature according to a first temperature coefficient ($TC_1$) related to the copper (or copper allow) material. The second resistance 412 may be a second material. For example, the second material may be silicon chromium (SiCr) (i.e., sichrome). The second resistance (i.e., $R_{SiCr}$) may change with temperature according to a second temperature coefficient ($TC_2$) related to the sichrome material.

The first resistance 411 and/or the second resistance 412 may be trimmable. Trimming the first resistance 411 and/or the second resistance 412 may include a wafer trim performed during fabrication or a switched trimmed. The switched trimmed implementation can include an array of parallel resistances which can be switched in or out of the array to adjust the resistance. The trimming may be used to provide balanced conditions (i.e., R1 = R3, R2 = R4) for the differential amplifier 460, as described above.

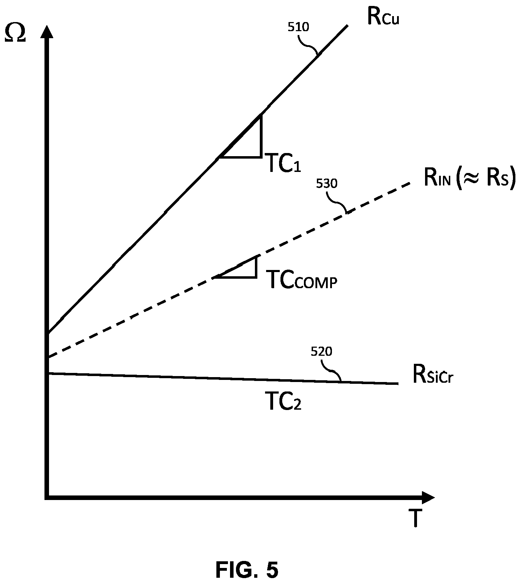

FIG. 5 are graphs that illustrate temperature responses of a composite resistance (RIN, input resistor 410) and its first resistance 411 ($R_{CU}$) and a second resistance 412 ($R_{SiCr}$) according to an implementation of the present disclosure. A first plot 510 illustrates a resistance ($\Omega$) increase with temperature (T) for the first resistance 411. A first slope of the first plot 510 corresponds to the first temperature coefficient (TC1) of the first resistance 411 ($R_{CU}$). A second plot 520 illustrates a resistance ($\Omega$) decrease with temperature (T) for the second resistance 412. A second slope of the second plot 520 corresponds to the second temperature coefficient (TC2) of the first resistance ($R_{SiCr}$). A third plot 530 illustrates a resistance ($\Omega$) increase with temperature (T) for the combination of the first resistance 411 and the second resistance 412 (i.e., the input resistor 410). A third slope of the third plot 530 corresponds to a composite temperature coefficient ($TC_{COMP}$) of the input resistance ($R_{Cu} + R_{SiCr}$), which can be adjusted via material selection and trimming to substantially match (e.g., < 1% difference) the lead-frame resistance ($R_S$).

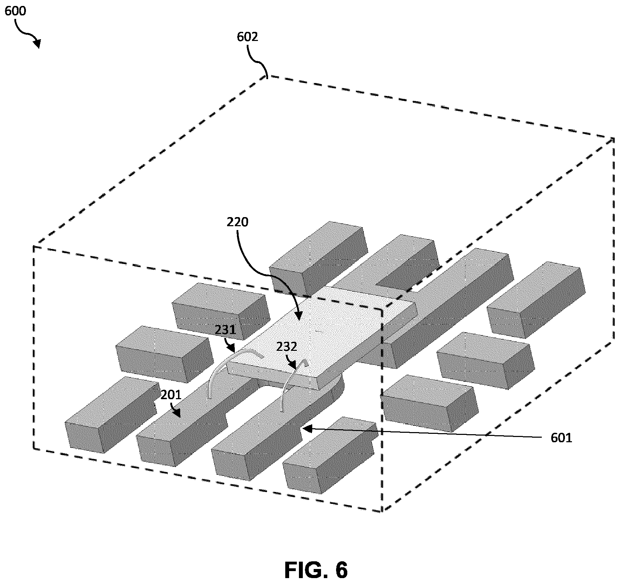

FIG. 6 is a perspective view of a package for a current sense circuit 110 according to a possible implementation of the present disclosure. The package 600 includes a die 220. The die is mounted (e.g., thermal epoxy) to a lead-frame 201. The lead-frame includes a first terminal portion connected to a first pad on the die via a first wire-bond 231. The lead-frame 201 further includes a second terminal portion connected to a second pad on the die via a second wire-bond 232. The lead-frame 201 further includes a step 601 from the terminal portion to a loop portion, and the die 220 is positioned contiguous to the loop portion. The die 220 and the lead-frame 201 form a thermal bond so the lead-frame 201 and the die 220 are at approximately (e.g., < 1 °C) the same temperature. The thermal coupling can increase an accuracy of the compensation. A volume 602 defined by the package 600 can be filled with injection molding material to complete the package. Portions of the lead frame may be free from the molding material to form connection points that can be soldered to a printed circuit board.

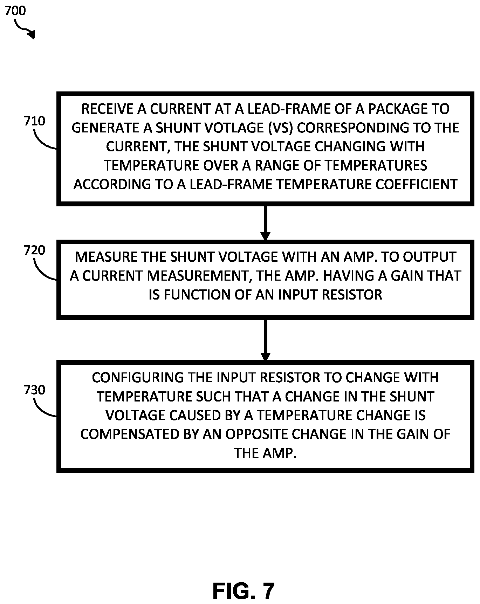

FIG. 7 is a flowchart of a method for reducing a variation in a current measurement according to a possible implementation of the present disclosure. The method 700 includes receiving 710 a current at a lead-frame of a package (e.g., of a current sense circuit) to generate a shunt voltage (VS), which corresponds to the current. The shunt voltage changes with temperature over a range of temperatures according to a lead-frame temperature coefficient. The method further includes measuring 720 the shunt voltage using an amplifier. The amplifier is configured to output a current measurement according to a gain that is a function of (i.e., is proportional to) an input resistor to the amplifier. The method 700 further includes configuring 730 the input resistor to change with temperature such that a change in the shunt voltage caused by a temperature change is compensated (i.e., offset) by an opposite change in the gain of the amplifier.

The compensation is carried out when a composite temperature coefficient of the input resistor matches the lead-frame temperature coefficient. This match can be achieved by adjusting the input resistor. The adjustment can be carried out by using a two (or more) series and/or parallel resistors as the input resistors, where each resistor has a different temperature coefficient corresponding to its resistance and its material so that the combination can be adjusted by adjusting the different resistances and/or materials for each resistor in the composite resistor until the composite temperature coefficient matches the lead-frame temperature coefficient.

The compensation may further include matching based on trimming the input resistor (e.g., a resistor in the composite resistor), adjustment the resistance of the lead-frame (e.g., wire-bond positions), and/or thermally coupling a die (including the amp) and the lead-frame.

In the specification and/or figures, typical embodiments have been disclosed. The present disclosure is not limited to such exemplary embodiments. The use of the term "and/or" includes any and all combinations of one or more of the associated listed items. The figures are schematic representations and so are not necessarily drawn to scale. Unless otherwise noted, specific terms have been used in a generic and descriptive sense and not for purposes of limitation.

Unless defined otherwise, all technical and scientific terms used herein have the same meaning as commonly understood by one of ordinary skill in the art. Methods and materials similar or equivalent to those described herein can be used in the practice or testing of the present disclosure. As used in the specification, and in the appended claims, the singular forms "a," "an," "the" include plural referents unless the context clearly dictates otherwise. The term "comprising" and variations thereof as used herein is used synonymously with the term "including" and variations thereof and are open, non-limiting terms. The terms "optional" or "optionally" used herein mean that the subsequently described feature, event or circumstance may or may not occur, and that the description includes instances where said feature, event or circumstance occurs and instances where it does not. Ranges may be expressed herein as from "about" one particular value, and/or to "about" another particular value. When such a range is expressed, an aspect includes from the one particular value and/or to the other particular value. Similarly, when values are expressed as approximations, by use of the antecedent "about," it will be understood that the particular value forms another aspect. It will be further understood that the endpoints of each of the ranges are significant both in relation to the other endpoint, and independently of the other endpoint.

Some implementations may be implemented using various semiconductor processing and/or packaging techniques. Some implementations may be implemented using various types of semiconductor processing techniques associated with semiconductor substrates including, but not limited to, for example, Silicon (Si), Gallium Arsenide (GaAs), Gallium Nitride (GaN), Silicon Carbide (SiC) and/or so forth.

While certain features of the described implementations have been illustrated as described herein, many modifications, substitutions, changes and equivalents will now occur to those skilled in the art. It is, therefore, to be understood that the appended claims are intended to cover all such modifications and changes as fall within the scope of the implementations. It should be understood that they have been presented by way of example only, not limitation, and various changes in form and details may be made. Any portion of the apparatus and/or methods described herein may be combined in any combination, except mutually exclusive combinations. The implementations described herein can include various combinations and/or subcombinations of the functions, components and/or features of the different implementations described.

It will be understood that, in the foregoing description, when an element is referred to as being on, connected to, electrically connected to, coupled to, or electrically coupled to another element, it may be directly on, connected or coupled to the other element, or one or more intervening elements may be present. In contrast, when an element is referred to as being directly on, directly connected to or directly coupled to another element, there are no intervening elements present. Although the terms directly on, directly connected to, or directly coupled to may not be used throughout the detailed description, elements that are shown as being directly on, directly connected or directly coupled can be referred to as such. The claims of the application, if any, may be amended to recite exemplary relationships described in the specification or shown in the figures.

As used in this specification, a singular form may, unless definitely indicating a particular case in terms of the context, include a plural form. Spatially relative terms (e.g., over, above, upper, under, beneath, below, lower, and so forth) are intended to encompass different orientations of the device in use or operation in addition to the orientation depicted in the figures. In some implementations, the relative terms above and below can, respectively, include vertically above and vertically below. In some implementations, the term adjacent can include laterally adjacent to or horizontally adjacent to.

**Claims**

1. A package for a current sense circuit comprising;

    a lead-frame having a shunt resistance configured to generate a shunt voltage between a positive terminal and a negative terminal, the shunt voltage corresponding to a current through the lead-frame, the shunt resistance having a variation with temperature according to a lead-frame temperature coefficient; and
    a die including a differential amplifier coupled to the positive terminal of the lead-frame and to the negative terminal of the lead-frame, the differential amplifier including:
    an input resistor having a composite temperature coefficient configured to match the lead-frame temperature coefficient such that an output of the differential amplifier is a measurement of the shunt voltage and such that the output is compensated to remove the variation caused by the lead-frame temperature coefficient.

2. The package for the current sense circuit according to claim 1, wherein:

    the input resistor includes a first resistance having a first temperature coefficient in series with a second resistance having a second temperature coefficient, the composite temperature coefficient being a combination of the first temperature coefficient and the second temperature coefficient;
    the first temperature coefficient is higher than the second temperature coefficient; and
    the lead-frame temperature coefficient is between the first temperature coefficient and the second temperature coefficient.

3. The package for the current sense circuit according to claim 2, wherein the first resistance is a first material, the second resistance is silicon chromium (SiCr), and the lead-frame is a copper alloy, the first material having a temperature coefficient greater than or equal to the copper alloy of the lead-frame.

4. The package for the current sense circuit according to any one of the preceding claims, wherein:

    the die including the differential amplifier is coupled by a first wire-bond to the positive terminal of the lead-frame and by a second wire-bond to the negative terminal of the lead-frame; and
    positions of the first wire-bond on the positive terminal and the second wire-bond on the negative terminal correspond to the shunt resistance.

5. The package for the current sense circuit according to any one of the preceding claims, wherein:

    the lead-frame includes a loop portion between the positive terminal and the negative terminal, a length of the loop portion corresponding to the shunt resistance;
    the loop portion has a loop thickness that is different from a terminal thickness of the positive terminal and the negative terminal, the terminal thickness corresponding to the shunt resistance; and
    the die is mechanically coupled and thermally coupled to the loop portion with thermal epoxy.

6. The package for the current sense circuit according to any one of the preceding claims, wherein the input resistor is a first resistor coupled between the negative terminal of the lead-frame and a positive input of an opamp, the differential amplifier further including:

    a second resistor coupled between the positive input of the opamp and a ground;
    a third resistor coupled between the positive terminal of the lead-frame and a negative input of the opamp; and
    a fourth resistor coupled between the negative input of the opamp and the output of the differential amplifier.

7. The package for the current sense circuit according to claim 6, wherein:

    the first resistor and the third resistor are approximately equal and are each a composite resistor that includes a copper or copper-alloy resistor and a silicon chromium resistor connected in series; and
    the second resistor and the fourth resistor are approximately equal and are each silicon chromium.

8. A method for reducing a variation in a current measurement, the method including:

    receiving a current at a lead-frame of a package to generate a shunt voltage corresponding to the current, the shunt voltage changing with temperature over a range according to a lead-frame temperature coefficient;

measuring the shunt voltage with an amplifier to output the current measurement, the amplifier having a gain that is a function of an input resistor; and

configuring the input resistor to change with temperature such that a change in the shunt voltage caused by a temperature change is compensated by an opposite change in the gain of the amplifier.

9. The method for reducing the variation in the current measurement according to claim 8, wherein:

the input resistor includes a first resistance in series with a second resistance and is configured to have a composite temperature coefficient that substantially matches the lead-frame temperature coefficient.

10. The method for reducing the variation in the current measurement according to claim 9, wherein configuring the input resistor further includes:

switching a number of resistances in a parallel array of resistances to trim the second resistance.

11. The method for reducing the variation in the current measurement according to any one of claims 8 to 10, further including:

positioning a wire-bond on the lead-frame to adjust a shunt resistance of the lead-frame, the shunt resistance corresponding to the lead-frame temperature coefficient.

12. The method for reducing the variation in the current measurement according to any one of claims 8 to 11, further including:

selecting a loop thickness of a loop portion of the lead-frame to adjust a shunt resistance of the lead-frame, the shunt resistance corresponding to the lead-frame temperature coefficient.

13. The method for reducing the variation in the current measurement according to any one of claims 8 to 12, further including:

bonding a die including the amplifier and the input resistor to the lead-frame in the package so that the lead-frame and the die are thermally coupled.

14. A current sense circuit comprising;

a lead-frame having a shunt resistance configured to generate a shunt voltage between a positive terminal and a negative terminal, the shunt voltage corresponding to a current through the lead-frame, the shunt voltage having a variation with temperature according to a lead-frame temperature coefficient; and

a differential amplifier coupled to the positive terminal of the lead-frame and to the negative terminal of the lead-frame, the differential amplifier including:

an input resistor including a first resistance of a first material in series with a second resistance of a second material, the input resistor having a composite temperature coefficient configured to match the lead-frame temperature coefficient such that the differential amplifier outputs a measurement of the shunt voltage that is compensated to remove the variation caused by the lead-frame temperature coefficient.

**FIG. 1**

EP 4 210 220 A1

FIG. 2

**FIG. 3B**

MAGNITUDE

$V_O$  G  $R_S$  $I_L$  T

**FIG. 3A**

MAGNITUDE

$V_O$  G  $R_S$  $I_L$  T

**FIG. 4**

**FIG. 5**

EP 4 210 220 A1

**FIG. 6**

700

710 — RECEIVE A CURRENT AT A LEAD-FRAME OF A PACKAGE TO GENERATE A SHUNT VOTLAGE (VS) CORRESPONDING TO THE CURRENT, THE SHUNT VOLTAGE CHANGING WITH TEMPERATURE OVER A RANGE OF TEMPERATURES ACCORDING TO A LEAD-FRAME TEMPERATURE COEFFICIENT

720 — MEASURE THE SHUNT VOLTAGE WITH AN AMP. TO OUTPUT A CURRENT MEASUREMENT, THE AMP. HAVING A GAIN THAT IS FUNCTION OF AN INPUT RESISTOR

730 — CONFIGURING THE INPUT RESISTOR TO CHANGE WITH TEMPERATURE SUCH THAT A CHANGE IN THE SHUNT VOLTAGE CAUSED BY A TEMPERATURE CHANGE IS COMPENSATED BY AN OPPOSITE CHANGE IN THE GAIN OF THE AMP.

**FIG. 7**

Europäisches
Patentamt

European
Patent Office

Office européen
des brevets

# EUROPEAN SEARCH REPORT

Application Number

EP 23 15 0393

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2011/089931 A1 (PODLISK ILIA [IL] ET AL) 21 April 2011 (2011-04-21) <br> * paragraph [0091] – paragraph [0103]; figures 9–11 * <br> ----- | 1–14 | INV. <br> H03F3/45 <br> H03F1/30 <br> H03G3/30 <br> G01R19/32 |
| Y | US 6 225 684 B1 (STITT II R MARK [US] ET AL) 1 May 2001 (2001-05-01) <br> * column 1, line 13 – column 2, line 39 * <br> * column 3, line 62 – column 8, line 14; figures 1,2 * <br> ----- | 1–14 | |
| A | US 2015/219690 A1 (KAYA CETIN [US]) 6 August 2015 (2015-08-06) <br> * paragraph [0015] – paragraph [0036]; figures 1–3 * <br> ----- | 1–14 | |
| A | US 2006/290408 A1 (OKADA HIROSHI [JP]) 28 December 2006 (2006-12-28) <br> * paragraph [0047] – paragraph [0050]; figure 1 * <br> ----- | 3,7 | |
| A | US 5 132 559 A (BASKETT IRA E [US]) 21 July 1992 (1992-07-21) <br> * column 3, line 62 – column 4, line 25; figure 2 * <br> ----- | 3,7 | TECHNICAL FIELDS SEARCHED (IPC) <br><br> H03F <br> H03G <br> G01R |
| A | US 2020/204185 A1 (HEALY JOHN P [IE] ET AL) 25 June 2020 (2020-06-25) <br> * paragraph [0042] – paragraph [0043]; figure 7 * <br> ----- | 3,7 | |
| A | US 2005/248336 A1 (SHARMA NIRMAL [US] ET AL) 10 November 2005 (2005-11-10) <br> * paragraph [0074] – paragraph [0083]; figure 9 * <br> ----- | 5,12 | |

The present search report has been drawn up for all claims

| Place of search | Date of completion of the search | Examiner |
|---|---|---|
| The Hague | 29 May 2023 | Wienema, David |

EPO FORM 1503 03.82 (P04C01)

**EP 4 210 220 A1**

## ANNEX TO THE EUROPEAN SEARCH REPORT
## ON EUROPEAN PATENT APPLICATION NO.

EP 23 15 0393

29-05-2023

| Patent document cited in search report | | Publication date | Patent family member(s) | | Publication date |
|---|---|---|---|---|---|
| US 2011089931 | A1 | 21-04-2011 | NONE | | |
| US 6225684 | B1 | 01-05-2001 | AT | 363079 T | 15-06-2007 |
| | | | DE | 60128510 T2 | 24-01-2008 |
| | | | EP | 1150129 A2 | 31-10-2001 |
| | | | JP | 3429750 B2 | 22-07-2003 |
| | | | JP | 2001284518 A | 12-10-2001 |
| | | | US | 6225684 B1 | 01-05-2001 |
| US 2015219690 | A1 | 06-08-2015 | US | 2015219690 A1 | 06-08-2015 |
| | | | US | 2018246144 A1 | 30-08-2018 |
| US 2006290408 | A1 | 28-12-2006 | JP | 4508001 B2 | 21-07-2010 |
| | | | JP | 2007005975 A | 11-01-2007 |
| | | | US | 2006290408 A1 | 28-12-2006 |
| US 5132559 | A | 21-07-1992 | NONE | | |
| US 2020204185 | A1 | 25-06-2020 | CN | 111355490 A | 30-06-2020 |
| | | | EP | 3672079 A1 | 24-06-2020 |
| | | | US | 10680633 B1 | 09-06-2020 |
| | | | US | 2020252074 A1 | 06-08-2020 |
| US 2005248336 | A1 | 10-11-2005 | NONE | | |

EPO FORM P0459

**REFERENCES CITED IN THE DESCRIPTION**

**Patent documents cited in the description**

- US 63297329